# EUROPEAN PATENT APPLICATION

(11) **EP 4 198 591 A1**
(43) Date of publication of application: **21.06.2023**
(21) Application number: 22206581.5
(22) Date of filing: 10.11.2022
(51) Int. Cl.: G02B 6/42

(54) **OPEN CAVITY PHOTONIC INTEGRATED CIRCUIT AND METHOD**

(30) Priority: 14.12.2021 US 202117550520
(71) Applicant: INTEL Corporation, Santa Clara, CA 95054 (US)
(72) Inventor: KARHADE, Omkar, Chandler, 85248 (US); CHIU, Chia-Pin, Tempe, 85284 (US); ROGERS, Finian, Newbridge (IE); LI, Xiaoqian, Chandler, 85248 (US); HOSSEINI, Kaveh, Livermore, 94550 (US)
(74) Representative: HGF

(57) **Abstract**

An electronic device and associated methods are disclosed. In one example, the electronic device includes a laser package. In selected examples, the laser package can include a substrate having a substrate front surface and defining a cavity that extends into the substrate front surface. The laser package can further include a photonic integrated circuit (PIC) attached to the substrate within the cavity at a first surface of the PIC, and laser circuitry communicably coupled to a second surface of the PIC opposite the first surface.

## Description

### Technical Field

Embodiments described herein generally relate to photonic integrated circuits (PICs) for use in electronic devices such as computer systems.

### Background

Optical interconnects offer very high bandwidths compared to electrical interconnects, and PICs can be used to convert electrical signals to optical signals in systems offering optical interconnects. Open cavities in the substrate can be used to enable more direct PIC to electrical IC connection. However, open cavities can cause issues with heat generation and mechanical stresses, among other problems. It is desired to have an open cavity PIC that can address these concerns, and other technical challenges.

### Brief Description of the Drawings

FIG. 1 shows integration of a laser on an open cavity PIC in accordance with some example embodiments.
FIG. 2A-2D show example methods of communication between laser circuitry and an open cavity PIC in accordance with some example embodiments.
FIG. 3A-3B show an electronic device including example structures for cooling laser circuitry in accordance with some example embodiments.
FIG. 4 shows an electronic device having a PIC overhang outside a substrate edge in accordance with some example embodiments.
FIG. 5 shows a photonic circuit package including structural silicon in accordance with some example embodiments.
FIG. 6A and 6B show alternative photonic circuit packages in accordance with some example embodiments.
FIG. 7 shows a flow diagram of a method of manufacture of an open cavity PIC with integrated laser circuitry in accordance with some example embodiments.
FIG. 8 shows a system that may incorporate an open cavity PIC and methods, in accordance with some example embodiments.

### Description of Embodiments

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

Optical interconnects offer very high bandwidths compared to electrical interconnects. Photonic ICs (PIC) are used to convert electrical signals to optical signals. Optical coupling is provided between a PIC and external packages to transfer optical signals out of the package. It is desirable to provide the PIC within an open cavity to enable direct electrical IC to PIC connection. Furthermore, it may be desirable to provide a relatively thin PIC (e.g., less than 50 microns (µm) thick) so that substrate routing layers are not consumed in cavity generation. However, providing such a thin PIC can make it more difficult to disperse or dissipate the heat that can be generated by any lasers that may be embedded in the open cavity PIC. In addition, with the open cavity PIC being embedded in the package substrate, a large coefficient of thermal expansion (CTE) difference may exist between the substrate and the open cavity PIC, and this difference can result in a large mechanical stress on the open cavity PIC. This mechanical stress can provide stress to any embedded laser as well, affecting laser performance and reliability.

Some current systems may address the above issues by placing a laser to one side of the open cavity PIC. However, this uses up valuable package real estate. In addition, because the laser in these solutions is mounted on the package substrate, the laser may still be subjected to stresses caused by the high CTE differential between the laser and substrate.

Systems and apparatuses according to various embodiments address these and other concerns by integrating a laser on the top of the open cavity PIC using, for example, a three-dimensional (3D) integration process. The heat generated by the laser can be conducted to an integrated heat spreader through a pedestal and thermal interface material (TIM), or through a thermo-electric cooler (TEC) and TIM.

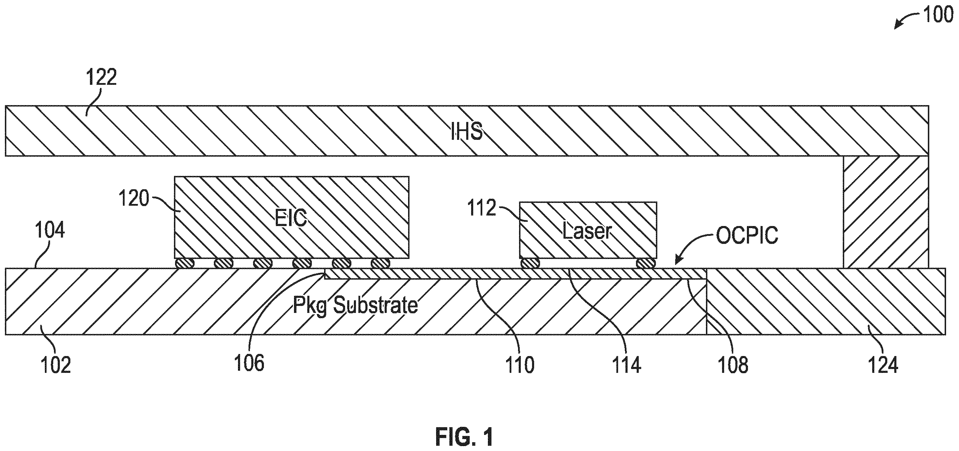

FIG. 1 shows a laser package 100 in accordance with some example embodiments. The laser package 100 can comprise a substrate 102 having a substrate front surface 104 and defining a cavity 106 that extends into the substrate front surface 104. The package 100 can comprise a PIC 108 attached to the substrate 102 within the cavity 106 at a first surface 110 of the PIC 108. The PIC 108 can be a PIC less than 100 µm thick, or less than 50 µm thick, for example. The laser package 100 can comprise laser circuitry 112 communicably coupled to a second surface 114 of the PIC 108 opposite the first surface 110. A substrate cutout area 124 is also shown.

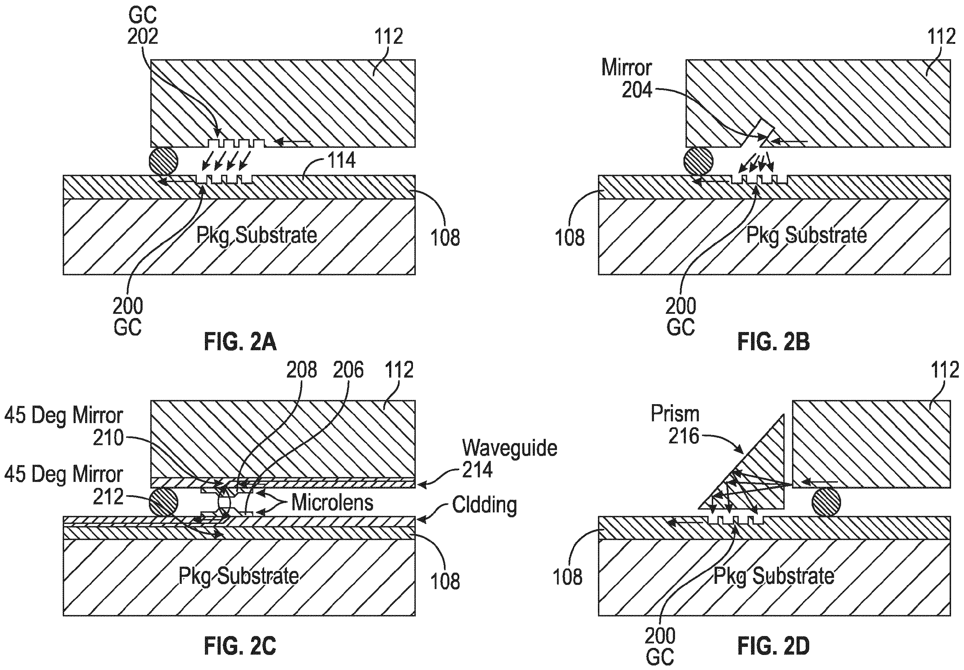

FIG. 2A-2D show example methods of communication between laser circuitry 112 and an open cavity PIC 108 in accordance with some example embodiments. In FIG. 2A, the second surface 114 of the PIC 108 can include a grating coupler (GC) 200. The laser circuitry 112 can include a GC 202 at a surface of the laser circuitry 112 facing the PIC 108. The laser circuitry 112 and the PIC 108 can then communicate using GC-to-GC communication. Direct communication to electronic integrated circuits (e.g., EIC 120) can be provided in structures according to embodiments. Integrated heat spreader (IHS 122) can provide a protective shell around the processing silicon and a pathway for heat to be exchanged or removed away from the components of FIG. 2A-2D.

In FIG. 2B, the laser circuitry 112 can include a mirror apparatus 204 at a surface of the laser circuitry 112 facing the PIC 108. The laser circuitry 112 and the PIC 108 can communicate using mirror-to-GC communication.

In FIG. 2C, the second surface of the PIC 108 can include a lens 206, and the laser circuitry 112 can include a lens 208 at a surface of the laser circuitry 112 facing the PIC 108. The laser circuitry and the PIC communicate using lens-to-lens communication. In some examples, the laser circuitry 112 can include a mirror 210 (for example a 45-degree mirror, although embodiments are not limited thereto), and the PIC 108 can include a similar mirror 212 and a waveguide 214 can guide a light signal from the laser circuitry 112 to the PIC 108 and through the mirrors 210, lens 206, and mirror 212. In some embodiments, cladding material may be included on the second surface of the PIC 108, and can include oxide cladding, for example, SiO2. In FIG. 2D, the laser package 100 can further comprise a prism 216 configured to provide communication between the laser circuitry 112 and the GC200 on the second surface of the PIC 108.

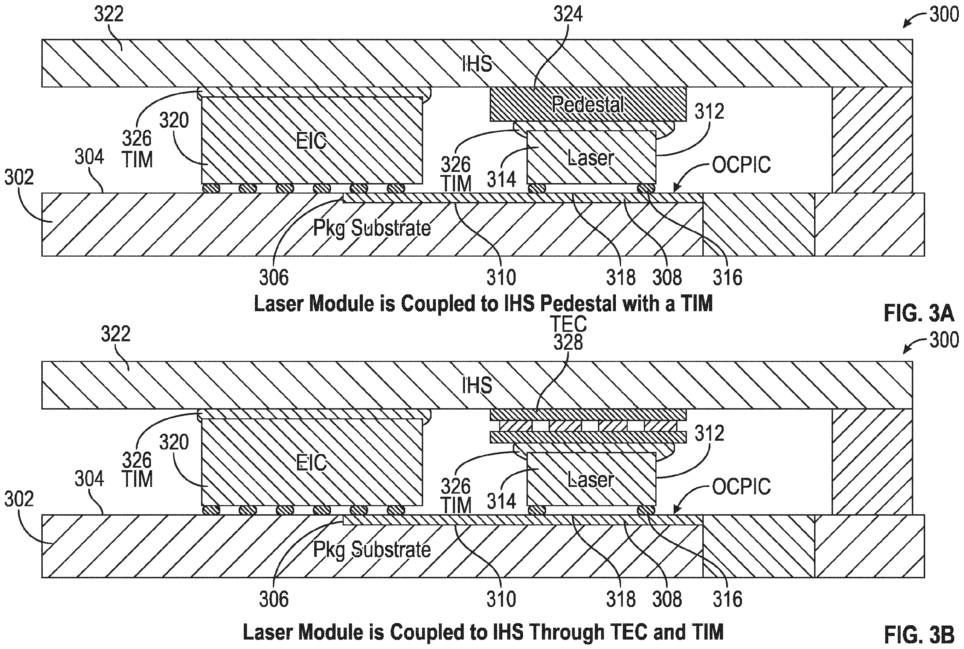

FIG. 3A-3B illustrates an electronic device 300 including example structures for cooling laser circuitry 312 in accordance with some example embodiments. The electronic device 300 can include a substrate 302 having a substrate front surface 304 and defining a cavity 306 that extends into the substrate front surface 304. The electronic device 300 can include a PIC 308 attached to the substrate 302 within the cavity 306 at a first surface 310 of the PIC 308. The electronic device 300 can include laser circuitry 312, having a first laser circuitry surface 316 and a second laser circuitry surface 314, communicably coupled at a first laser circuit surface 316 to a second surface 318 of the PIC opposite the first surface 310.

The electronic device 300 can include an integrated circuit 320 coupled to the second surface of the PIC 308 for electrical communication external to the electronic device 300. The electronic device 300 can include a heat spreader 322 above the second laser circuitry surface 314. A pedestal 324 can couple the heat spreader 322 to the second laser circuitry surface 314. In embodiments, the pedestal 324 can be coupled to the second laser circuitry surface 314 through a thermal interface material (TIM) 326, which can include, for example a grease that is impregnated with thermal conductor particles (carbon, nanotubes, metals, etc.). In examples such as an example depicted in FIG. 3B, instead of or in addition to the pedestal 324, the TIM 326 and a thermo-electric cooler (TEC) 328 can couple the heat spreader 322 to the second laser circuitry surface 314. The pedestal 324 can be comprised of a same material as the heat spreader 322 (e.g., copper, aluminum or aluminum alloy, SiC, steel, diamond or other thermal conductors) and the pedestal 324 and heat spreader 322 can form one piece. The laser circuitry 312 can be substantially thicker (e.g., up to about 760 µm thick) than the PIC 308. This can help the laser circuitry 312 spread heat in a lateral direction or additional heat dissipation. The TIM 326 should be about 50-100 µm thick. TIM 326 thickness can be determined by thermal budget and the tolerance of the laser component height.

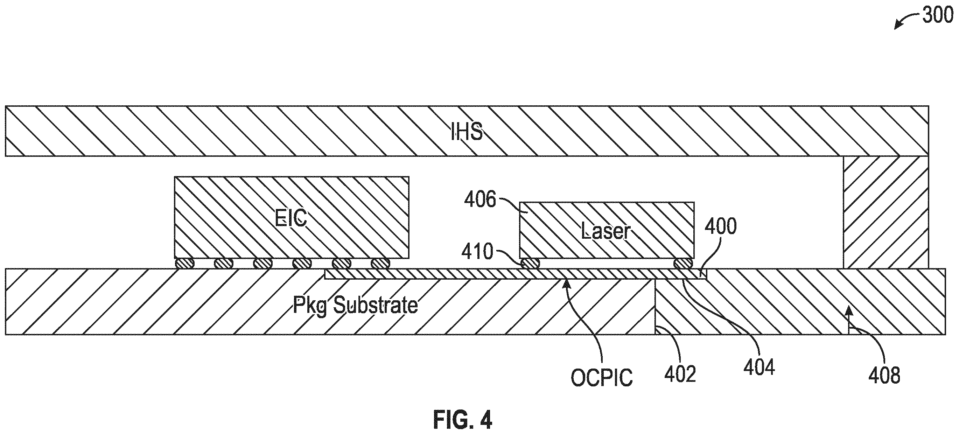

FIG. 4 shows an electronic device 300 having a PIC 400 that overhangs past an outer substrate edge 402 for an overhang portion 404. In some embodiments, the laser circuitry 406 can support the PIC 400 mechanically so that if force is applied in an upward direction 408 to the overhang portion 404, the PIC 400 is prevented from breaking off. It will be noted also that die bumps 410 of the laser circuitry 406 can be arranged to prevent the bumps 410 from overlapping with the active region of the laser diode in the laser circuitry 406 to minimize the stress impact on the laser performance and reliability.

Example embodiments as described with reference to FIG. 1-4 can provide stacking to save real estate on IC packages. In addition, because the laser can be separated from the package substrate, the stress introduced by the high-CTE substrate can be reduced. Because the laser can be more proximate the integrated heat spreader (IHS 122) than the PIC, the heat generated by the laser can be conducted more easily to the IHS 122 through a pedestal, TEC or TIM. Furthermore, because the laser can be thicker than the PIC, the laser can spread heat in a lateral direction for further heat dissipation. In some embodiments, the laser can provide mechanical support for the PIC, especially in embodiments having the PIC overhang an edge of the package substrate.

Open cavity PICs, and particularly thin (less than 50 µm) PICs, can be subject to warpage when attached or coupled to packages within electronic devices. Overhang of the PIC over the substrate edge, as shown above in FIG. 4, can increase chance of breakage or warpage, but overhang is needed to attach optical fiber to a PIC.

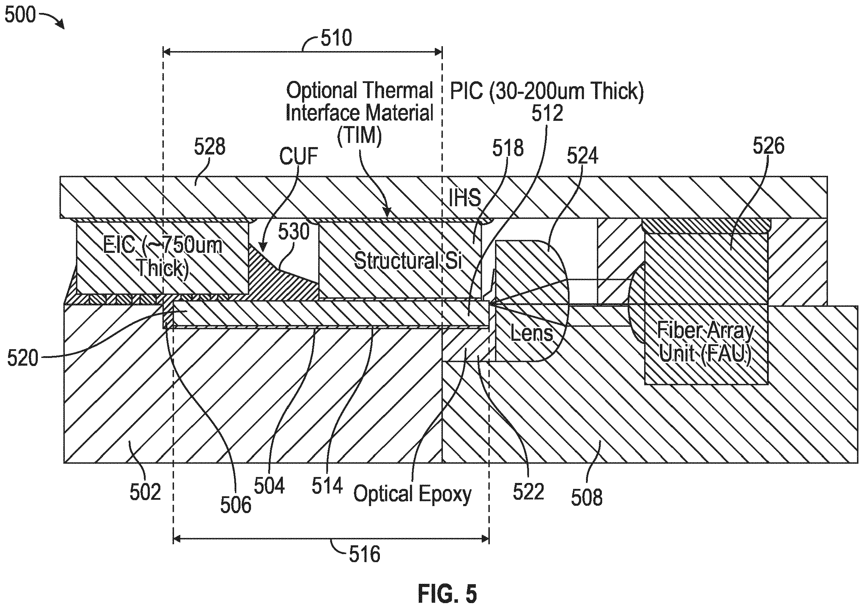

To address these and other concerns, packages in accordance with some embodiments can provide structures to prevent warpage of a PIC where optical fiber or a lens is attached. FIG. 5 shows a photonic circuit package 500 including structural silicon in accordance with some example embodiments.

The photonic circuit package 500 can include a substrate 502 having a substrate front surface 504 defining a cavity 506 that extends into the substrate front surface 504. The substrate 502 can further include a leading edge 508. The cavity 506 can have a cavity length 510. The photonic circuit package 500 can further include a PIC 512 attached to the substrate 502 within the cavity 506 at a first surface 514 of the PIC 512 and having a PIC length 516 greater than the cavity length 510 such that the PIC 512 extends beyond the leading edge 508 of the substrate 502. The PIC 512 can be about 30-200 µm thick.

The photonic circuit package 500 can include a die structure 518 that will not include circuitry but be comprised at least mostly of a structural material such as silicon (Si). The die structure 518 can be attached to a second surface 520 of the PIC 512 opposite the first surface 514 of the PIC 512. In some embodiments, the die structure 518 can extend past the leading edge 508.

In some example embodiments, an optical epoxy 522 can be attached to the PIC 512 at least at a portion of the PIC 512 that extends beyond the leading edge 508 of the substrate 502. The photonic circuit package 500 can comprise a lens 524 coupled to the optical epoxy 522 to provide optical communication from the PIC 512. The die structure 518 can provide further support for attachment of the lens 524, the optical epoxy 522, and a fiber attach unit 526. The die structure 518 can thermally connect the PIC 512 to a heat spreader 528 for cooling the PIC 512. The die structure 518 can further help stop capillary underfill (CUF) 530 from spreading to the optical attach side.

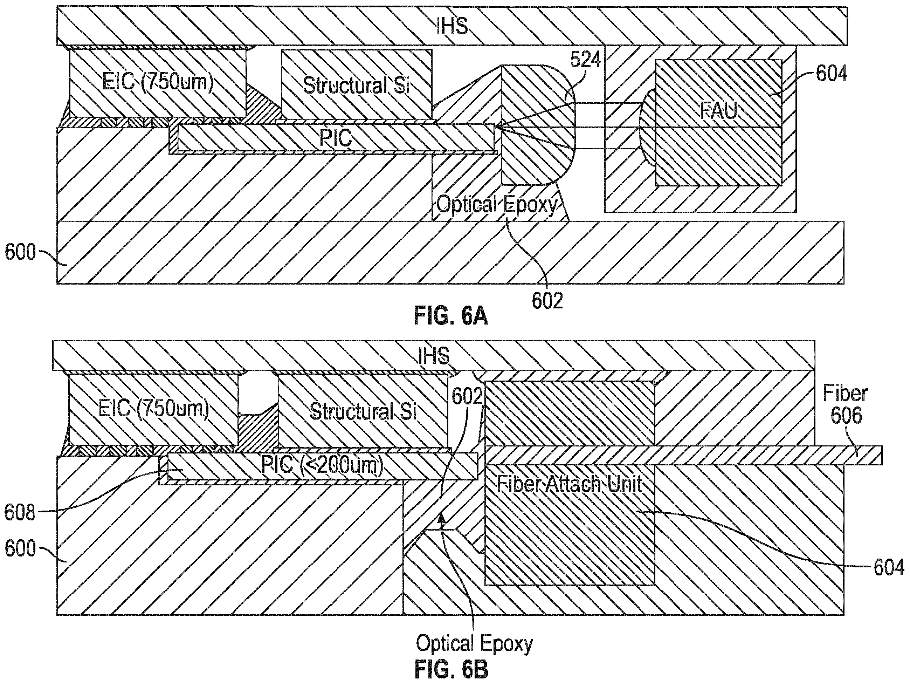

Alternative embodiments of the photonic circuit package are shown in FIG. 6A and FIG. 6B. In FIG. 6A, the lens 524 can be attached to the substrate 600 with the optical epoxy 602, and the fiber attach unit 604 may also be attached to the substrate 600 to provide more stability for the lens, and/or more stable coupling between the lens and FAU. In FIG. 6B, the lens may be removed and fiber 606 may be attached through the fiber attach unit 604 to optically couple to the PIC 608 through the optical epoxy 602. This can reduce expense and complexity by removal of the lens.

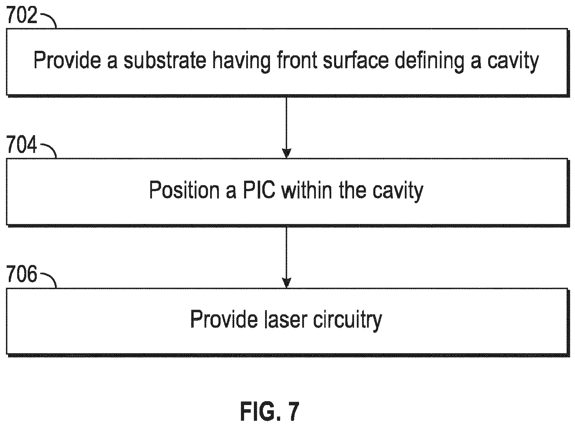

FIG. 7 shows a flow diagram of a method of manufacture of an open cavity PIC with integrated laser circuitry in accordance with some example embodiments. The method can begin with operation 702 with providing a substrate 102 (FIG. 1). The substrate 102 can have a substrate front surface 104 and define a cavity 106 that extends into the substrate front surface 104.

The method can continue with operation 704 with positioning a PIC 108 within the cavity 106 at a first surface 110 of the PIC 108. The method can continue with operation 706 by providing laser circuitry 112 communicably coupled to a second surface 114 of the PIC 108 opposite the first surface 110.

The method can further comprise providing a grating coupler 200 within the second surface 114 of the PIC 108 and providing at least one of a GC 202 at a surface of the laser circuitry 112 facing the PIC 108 and a mirror apparatus 204 at the surface of the laser circuitry facing the PIC 108 for communication with the GC 200 within the second surface 114 of the PIC 108.

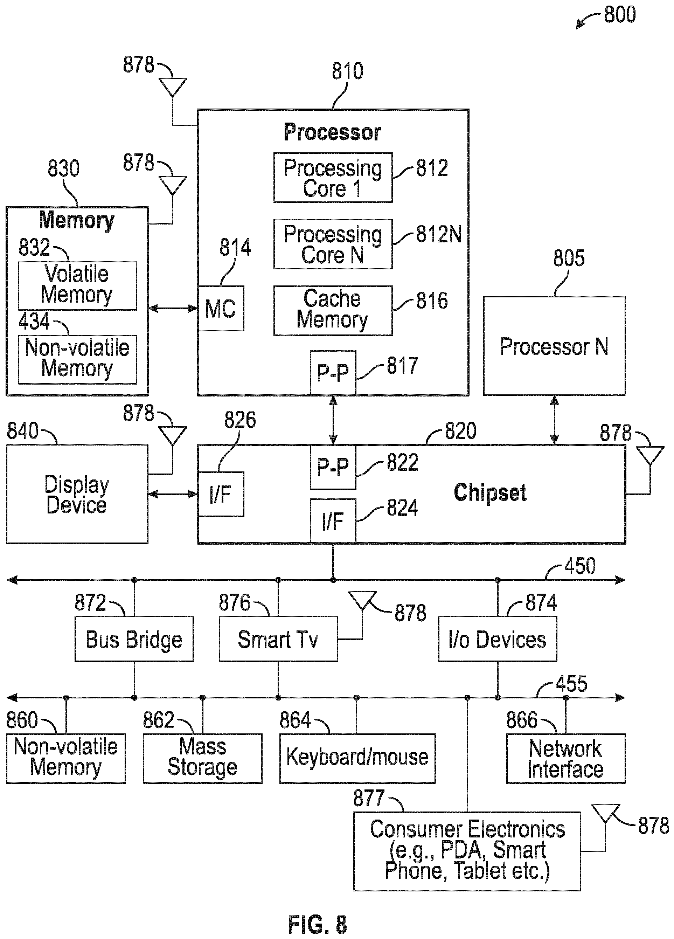

FIG. 8 illustrates a system level diagram, depicting an example of an electronic device (e.g., system) that may include an open cavity PIC and/or methods described above. In one embodiment, system 800 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 800 includes a system on a chip (SOC) system.

In one embodiment, processor 810 has one or more processor cores 812 and 812N, where 612N represents the Nth processor core inside processor 810 where N is a positive integer. In one embodiment, system 800 includes multiple processors including 810 and 805, where processor 805 has logic similar or identical to the logic of processor 810. In some embodiments, processing core 812 includes, but is not limited to, pre-fetch logic to fetch instructions, decode logic to decode the instructions, execution logic to execute instructions and the like. In some embodiments, processor 810 has a cache memory 816 to cache instructions and/or data for system 800. Cache memory 816 may be organized into a hierarchal structure including one or more levels of cache memory.

In some embodiments, processor 810 includes a memory controller 814, which is operable to perform functions that enable the processor 810 to access and communicate with memory 830 that includes a volatile memory 832 and/or a non-volatile memory 834. In some embodiments, processor 810 is coupled with memory 830 and chipset 820. Processor 810 may also be coupled to a wireless antenna 878 to communicate with any device configured to transmit and/or receive wireless signals. In one embodiment, an interface for wireless antenna 878 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 832 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 834 includes, but is not limited to, flash memory, phase change memory (PCM), read-only memory (ROM), electrically erasable programmable read-only memory (EEPROM), or any other type of non-volatile memory device.

Memory 830 stores information and instructions to be executed by processor 810. In one embodiment, memory 830 may also store temporary variables or other intermediate information while processor 810 is executing instructions. In the illustrated embodiment, chipset 820 connects with processor 810 via Point-to-Point (PtP or P-P) interfaces 817 and 822. Chipset 620 enables processor 810 to connect to other elements in system 800. In some embodiments of the example system, interfaces 817 and 822 operate in accordance with a PtP communication protocol such as the Intel^{®} QuickPath Interconnect (QPI) or the like. In other embodiments, a different interconnect may be used.

In some embodiments, chipset 820 is operable to communicate with processor 810, 805N, display device 840, and other devices, including a bus bridge 872, a smart TV 876, I/O devices 874, nonvolatile memory 860, a storage medium (such as one or more mass storage devices) 862, a keyboard/mouse 864, a network interface 866, and various forms of consumer electronics 877 (such as a PDA, smart phone, tablet etc.), etc. In one embodiment, chipset 820 couples with these devices through an interface 824. Chipset 820 may also be coupled to a wireless antenna 878 to communicate with any device configured to transmit and/or receive wireless signals. In one example, any combination of components in a chipset may be separated by a continuous flexible shield as described in the present disclosure.

Chipset 820 connects to display device 840 via interface 826. Display 840 may be, for example, a liquid crystal display (LCD), a light emitting diode (LED) array, an organic light emitting diode (OLED) array, or any other form of visual display device. In some embodiments of the example system, processor 810 and chipset 820 are merged into a single SOC. In addition, chipset 820 connects to one or more buses 850 and 855 that interconnect various system elements, such as I/O devices 874, nonvolatile memory 860, storage medium 862, a keyboard/mouse 864, and network interface 866. Buses 850 and 855 may be interconnected together via a bus bridge 872.

In one embodiment, mass storage device 862 includes, but is not limited to, a solid state drive, a hard disk drive, a universal serial bus flash memory drive, or any other form of computer data storage medium. In one embodiment, network interface 866 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 8 are depicted as separate blocks within the system 800, the functions performed by some of these blocks may be integrated within a single semiconductor circuit or may be implemented using two or more separate integrated circuits. For example, although cache memory 816 is depicted as a separate block within processor 810, cache memory 816 (or selected aspects of 816) can be incorporated into processor core 812.

To better illustrate the method and apparatuses disclosed herein, a non-limiting list of embodiments is provided here:
Example 1 includes a laser package, comprising: a substrate having a substrate front surface and defining a cavity that extends into the substrate front surface; a photonic integrated circuit (PIC) attached to the substrate within the cavity at a first surface of the PIC; and laser circuitry communicably coupled to a second surface of the PIC opposite the first surface.
Example 2 includes the laser package of example 1, wherein the second surface of the PIC includes a grating coupler (GC).
Example 3 includes the laser package of any one of examples 1-2, wherein the laser circuitry includes a GC at a surface of the laser circuitry facing the PIC, and wherein the laser circuitry and the PIC communicate using GC-to-GC communication.
Example 4 includes the laser package of any one of examples 1-3, wherein the laser circuitry includes a mirror apparatus at a surface of the laser circuitry facing the PIC, and wherein the laser circuitry and the PIC communicate using mirror-to-GC communication.
Example 5 includes the laser package of any one of examples 1-4, further comprising a prism configured to provide communication between the laser circuitry and the GC on the second surface of the PIC.
Example 6 includes the laser package of any of examples 1-5, wherein the second surface of the PIC includes a lens, the laser circuitry includes a lens at a surface of the laser circuitry facing the PIC, and wherein the laser circuitry and the PIC communicate using lens-to-lens communication.
Example 7 includes the laser package of any of examples 1-6, wherein the PIC is less than 100 micrometers thick.
Example 8 includes the laser package of any of examples 1-7, wherein the PIC is less than 50 micrometers thick.
Example 9 includes the laser package of any of examples 1-8, wherein the PIC overhangs past an outer edge of the substrate for an overhang portion.
Example 10 includes the laser package of any of examples 1-9, wherein at least a portion of the laser circuitry extends over at least a portion of the overhang portion.
Example 11 includes an electronic device comprising a substrate having a substrate front surface and defining a cavity that extends into the substrate front surface; a photonic integrated circuit (PIC) attached to the substrate within the cavity at a first surface of the PIC; laser circuitry, having a first laser circuitry surface and a second laser circuitry surface, communicably coupled at a first surface to a second surface of the PIC opposite the first surface; an integrated circuit coupled to the second surface of the PIC for electrical communication external to the electronic device; and a heat spreader above the second laser circuitry surface.
Example 12 includes an electronic device of example 11, and optionally further comprising a pedestal to couple the heat spreader to the second laser circuitry surface.
Example 13 includes an electronic device of any of examples 11-12, and optionally wherein the pedestal is coupled to the second laser circuitry surface through a thermal interface material.
Example 14 includes an electronic device of any of examples 11-13, and optionally further comprising a thermal interface material and a thermo-electric cooler to couple the heat spreader to the second laser circuitry surface.
Example 15 includes an electronic device of any of examples 11-14, optionally wherein the second surface of the PIC includes a grating coupler (GC), the laser circuitry includes a GC at a surface of the laser circuitry facing the PIC, and the laser circuitry and the PIC communicate using GC-to-GC communication.
Example 16 includes an electronic device of any of examples 11-15, optionally wherein the second surface of the PIC includes a grating coupler (GC), the laser circuitry includes a mirror apparatus at a surface of the laser circuitry facing the PIC, and the laser circuitry and the PIC communicate using mirror-to-GC communication.
Example 17 is a method for assembling a laser package, the method comprising: providing a substrate, the substrate having a substrate front surface and defining a cavity that extends into the substrate front surface; positioning a photonic integrated circuit (PIC) within the cavity at a first surface of the PIC; and providing laser circuitry communicably coupled to a second surface of the PIC opposite the first surface.
Example 18 includes the method of example 17, and optionally further comprising providing a grating coupler (GC) within the second surface of the PIC; and providing at least one of a GC at a surface of the laser circuitry facing the PIC and a mirror apparatus at the surface of the laser circuitry facing the PIC for communication with the GC within the second surface of the PIC.
Example 19 includes a photonic circuit package comprising a substrate having a substrate front surface defining a cavity that extends into the substrate front surface, the substrate further including a leading edge and the cavity having a cavity length; a photonic integrated circuit (PIC) attached to the substrate within the cavity at a first surface of the PIC and having a PIC length greater than the cavity length such that the PIC extends beyond the leading edge of the substrate; and a die structure comprised of a structural material, the die structure attached to a second surface of the PIC opposite the first surface of the PIC.
Example 20 includes the photonic circuit package of example 19, and optionally wherein the die structure extends past the leading edge.
Example 21 includes the photonic circuit package of any of examples 19-20 wherein an optical epoxy is attached to the PIC at least at a portion of the PIC that extends beyond the leading edge of the substrate.
Example 22 includes the photonic circuit package of any of examples 19-21, and optionally further comprising a fiber attach mechanism coupled to the optical epoxy, and an optical fiber within the fiber attach mechanism to provide optical communication from the PIC.
Example 23 includes the photonic circuit package of any of examples 19-22, optionally further comprising a lens coupled to the optical epoxy to provide optical communication from the PIC.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Although an overview of the inventive subject matter has been described with reference to specific example embodiments, various modifications and changes may be made to these embodiments without departing from the broader scope of embodiments of the present disclosure. Such embodiments of the inventive subject matter may be referred to herein, individually, or collectively, by the term "invention" merely for convenience and without intending to voluntarily limit the scope of this application to any single disclosure or inventive concept if more than one is, in fact, disclosed.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

As used herein, the term "or" may be construed in either an inclusive or exclusive sense. Moreover, plural instances may be provided for resources, operations, or structures described herein as a single instance. Additionally, boundaries between various resources, operations, modules, engines, and data stores are somewhat arbitrary, and particular operations are illustrated in a context of specific illustrative configurations. Other allocations of functionality are envisioned and may fall within a scope of various embodiments of the present disclosure. In general, structures and functionality presented as separate resources in the example configurations may be implemented as a combined structure or resource. Similarly, structures and functionality presented as a single resource may be implemented as separate resources. These and other variations, modifications, additions, and improvements fall within a scope of embodiments of the present disclosure as represented by the appended claims. The specification and drawings are, accordingly, to be regarded in an illustrative rather than a restrictive sense.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

It will also be understood that, although the terms "first," "second," and so forth may be used herein to describe various elements, these elements should not be limited by these terms. These terms are only used to distinguish one element from another. For example, a first contact could be termed a second contact, and, similarly, a second contact could be termed a first contact, without departing from the scope of the present example embodiments. The first contact and the second contact are both contacts, but they are not the same contact.

The terminology used in the description of the example embodiments herein is for the purpose of describing particular example embodiments only and is not intended to be limiting. As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' may be construed to mean "when" or "upon" or "in response to determining" or "in response to detecting," depending on the context. Similarly, the phrase "if it is determined" or "if [a stated condition or event] is detected" may be construed to mean "upon determining" or "in response to determining" or "upon detecting [the stated condition or event]" or "in response to detecting [the stated condition or event]," depending on the context.

## Claims

1. A laser package, comprising:
a substrate having a substrate front surface and defining a cavity that extends into the substrate front surface;
a photonic integrated circuit (PIC) attached to the substrate within the cavity at a first surface of the PIC; and
laser circuitry communicably coupled to a second surface of the PIC opposite the first surface.

2. The laser package of claim 1, wherein the second surface of the PIC includes a grating coupler (GC).

3. The laser package of claim 2, wherein the laser circuitry includes a GC at a surface of the laser circuitry facing the PIC, and wherein the laser circuitry and the PIC communicate using GC-to-GC communication.

4. The laser package of claim 2, wherein the laser circuitry includes a mirror apparatus at a surface of the laser circuitry facing the PIC, and wherein the laser circuitry and the PIC communicate using mirror-to-GC communication.

5. The laser package of claim 2, further comprising a prism configured to provide communication between the laser circuitry and the GC on the second surface of the PIC.

6. The laser package of any of claims 1-5, wherein the second surface of the PIC includes a lens, the laser circuitry includes a lens at a surface of the laser circuitry facing the PIC, and wherein the laser circuitry and the PIC communicate using lens-to-lens communication.

7. The laser package of claim 1, wherein the PIC is less than 100 micrometers thick.

8. The laser package of claim 7, wherein the PIC is less than 50 micrometers thick.

9. The laser package of claim 1, wherein the PIC overhangs past an outer edge of the substrate for an overhang portion.

10. The laser package of claim 9, wherein at least a portion of the laser circuitry extends over at least a portion of the overhang portion.

11. A method for assembling a laser package, the method comprising:
providing a substrate, the substrate having a substrate front surface and defining a cavity that extends into the substrate front surface;
positioning a photonic integrated circuit (PIC) within the cavity at a first surface of the PIC; and providing laser circuitry communicably coupled to a second surface of the PIC opposite the first surface.

12. The method of claim 11, further comprising:
providing a grating coupler (GC) within the second surface of the PIC; and
providing at least one of a GC at a surface of the laser circuitry facing the PIC and a mirror apparatus at the surface of the laser circuitry facing the PIC for communication with the GC within the second surface of the PIC.

13. A system comprising:
means for performing any of claims 1-12.
